# EUROPEAN PATENT APPLICATION

(11) **EP 4 287 062 A1**
(43) Date of publication of application: **06.12.2023**
(21) Application number: 22783272.2
(22) Date of filing: 19.04.2022
(51) Int. Cl.: G06F 30/392, G06F 30/394, G06F 30/398

(54) **LAYOUT AND WIRING METHOD THEREFOR, AND COMPARISON METHOD, PREPARATION METHOD, DEVICE AND STORAGE MEDIUM**

(30) Priority: 11.04.2022 CN 202210377288
(71) Applicant: Changxin Memory Technologies, Inc., Hefei City, Anhui 230601 (CN)
(72) Inventor: LI, Zhonghua, Hefei Anhui 230601 (CN); SONG, Zhihao, Hefei Anhui 230601 (CN)
(74) Representative: V.O.
(86) International application number: PCT/CN2022/087763
(87) International publication number: WO 2023/197344

(57) **Abstract**

Embodiments of the disclosure relate to the field of semiconductor technologies, and provide a layout and a wiring method, a comparison method, a fabrication method, a device, and a storage medium. The layout wiring method includes: obtaining names of all ports (100) in a layout, each port (100) has a first node(110) and a second node (120); detecting whether the first node (110) and the second node (120) of each port (100) are each connected to any other port (100) through an actual connection layer (101), and if not, taking a port (100) of which the first node (110) and/or the second node (120) are not connected to the actual connection layer (101) as a port to be connected (130); and connecting at least two ports to be connected (130) having the same name using a virtual connection layer (102). The embodiments of the disclosure at least facilitate reducing the number of modifications in layout wiring, and facilitate improving the accuracy and efficiency of layout wiring.

## Description

### CROSS-REFERENCE TO RELATED APPLICATION

This application claims priority to Chinese Patent Application No. 202210377288.9, filed on April 11, 2022 and entitled "LAYOUT AND WIRING METHOD, COMPARISON METHOD, FABRICATION METHOD, DEVICE, AND STORAGE MEDIUM", the disclosure of which is hereby incorporated by reference in its entirety.

### TECHNICAL FIELD

Embodiments of the disclosure relate to the field of semiconductor technologies, and in particular, to a layout and a wiring method, a comparison method, a fabrication method, a device, and a storage medium.

### BACKGROUND

In the integrated circuit design process, whether the designed circuit functions are consistent with requirements needs to be verified in each design stage. In the back-end stage of the design process, that is, after a layout is designed according to a schematic, Layout Versus Schematic (LVS) is used to confirm whether the circuit layout is consistent with the schematic thereof.

However, there is no internal circuit in the layout, but partial structures in the schematic are connected through an internal circuit, so that a connection relationship between the partial structures cannot be embodied in the layout, thereby causing inconsistency between the layout and the schematic, and further affecting the accuracy and efficiency of layout wiring.

### SUMMARY

Embodiments of the disclosure provide a layout and a wiring method, a comparison method, a fabrication method, a device, and a storage medium. The layout wiring method at least facilitates improving the accuracy and efficiency of layout wiring.

According to some embodiments of the disclosure, one aspect of the embodiments of the disclosure provides a layout wiring method, which includes: names of all ports in a layout are obtained, where each port has a first node and a second node; it is detected whether the first node and the second node of each port are each connected to any other port through an actual connection layer, and if not, a port of which at least one of the first node or the second node is not connected to the actual connection layer is taken as a port to be connected; and at least two ports to be connected having the same name are connected by using a virtual connection layer.

In some embodiments, the layout wiring method may further include: before the at least two ports to be connected having the same name are connected by using the virtual connection layer, a number of ports to be connected is obtained; and if the number of ports to be connected is at least three, the operation that the at least two ports to be connected having the same name are connected by using the virtual connection layer includes operations that connection relationships between all ports having the same name are detected, and any one of the ports are connected to other two ports having the same name through at least one of the virtual connection layer or the actual connection layer, where all ports having the same name form a connection loop through the virtual connection layer and the actual connection layer.

In some embodiments, the layout wiring method may further include: before the at least two ports to be connected having the same name are connected by using the virtual connection layer, a port to be connected of which both the first node and the second node are not connected to any other port through the actual connection layer ia taken as a target port; and the operation that the at least two ports to be connected having the same name are connected by using the virtual connection layer includes operations that information of distances from the first node and the second node of the target port to other ports to be connected having the same name is obtained; and on the basis of the information of distances, the first node of the target port is connected to a port to be connected closest to the first node of the target port by using the virtual connection layer, and the second node of the target port is connected to a port to be connected closest to the second node of the target port by using the virtual connection layer.

According to some embodiments of the disclosure, another aspect of the embodiments of the disclosure further provides a layout versus schematic comparison method, which includes: a layout and a schematic corresponding to the layout are provided, where the layout includes at least two ports having a same name and at least one virtual connection layer connecting two ports; any one virtual connection layer is selected as a target virtual connection layer, and on a premise that the target virtual connection layer is not identified, layout versus schematic comparison is performed to obtain a first result; and on a premise that the target virtual connection layer is identified, layout versus schematic comparison is performed to obtain a second result, where if the first result indicates a virtual connection error, and the second result indicates no abnormality, it is indicated that the layout meets requirements.

In some embodiments, the layout versus schematic comparison method may further include: if the first result indicates a virtual connection error, and the second result indicates an abnormality, it is detected whether ports connected by the target virtual connection layer are correct; and two other ports that need to be tested are connected by using the target virtual connection layer, so as to re-obtain the first result and the second result until the layout meets the requirements.

In some embodiments, the layout versus schematic comparison method may further include: all virtual connection layers are traversed, so that each of the virtual connection layers serves as the target virtual connection layer once.

According to some embodiments of the disclosure, still another aspect of the embodiments of the disclosure further provides a layout versus schematic comparison method, which includes: a layout and a schematic corresponding to the layout are provided, where the layout includes at least two ports having a same name, and the layout does not include a virtual connection layer; and on a premise that the virtual connection layer is not identified, layout versus schematic comparison is performed to obtain a first result, where if the first result indicates no abnormality, it is indicated that the layout meets requirements.

In some embodiments, if the first result indicates a virtual connection error, the layout versus schematic comparison method may further include: at least two ports that need to be tested are connected by using the virtual connection layer; and on a premise that the virtual connection layer is identified, the layout versus schematic comparison is performed to obtain a second result, where if the second result indicates no abnormality, it is indicated that the layout meets the requirements.

In some embodiments, if the second result indicates an abnormality, the layout versus schematic comparison method may further include: at least two other ports that need to be tested are connected by using the virtual connection layer, so as to re-obtain at least one of the first result or the second result until the layout meets the requirements.

According to some embodiments of the disclosure, yet another aspect of the embodiments of the disclosure further provides a layout, which includes: at least two ports having the same name, where each port has a first node and a second node; an actual connection layer, connecting some of the ports having the same name, where some of the ports having the same name each has at least one of the first node or the second node which is not connected to the actual connection layer, and a port of which at least one of the first node or the second node is not connected to the actual connection layer is taken as a port to be connected; and a virtual connection layer, connecting at least two ports to be connected having the same name.

In some embodiments, a number of ports to be connected is at least three, any one of the ports is connected to the other two ports through at least one of the virtual connection layer or the actual connection layer, and all ports having the same name form a connection loop through the virtual connection layer and the actual connection layer.

In some embodiments, some of the ports to be connected each has a first node and a second node which are all not connected to the actual connection layer, and a port to be connected of which the first node and the second node are not connected to the actual connection layer is taken as a target port, where the virtual connection layer connects the first node of the target port to a port to be connected closest to the first node of the target port, and the virtual connection layer connects the second node of the target port to a port to be connected closest to the second node of the target port.

According to some embodiments of the disclosure, yet another aspect of the embodiments of the disclosure further provides a circuit fabrication method, which includes: a circuit is fabricated according to a layout formed by the layout wiring method of any one of the above, or a circuit is fabricated according to the layout of any one of the above, where in the process of fabricating the circuit, a virtual connection layer does not participate in production of fabricating the circuit, and the virtual electric connection layer is not embodied in the circuit.

According to some embodiments of the disclosure, yet another aspect of the embodiments of the disclosure further provides an electronic device, which includes: at least one processor; and a memory communicatively connected to the at least one processor, where the memory has stored therein instructions executable by the at least one processor, and the instructions are executed by the at least one processor, to cause the at least one processor can to execute the layout wiring method according to any one of the above, or the instructions are executed by the at least one processor, to cause the at least one processor to execute the layout versus schematic comparison method according to any one of the above.

According to some embodiments of the disclosure, yet another aspect of the embodiments of the disclosure further provides a computer readable storage medium, storing a computer program, where the computer program, when executed by a processor, implements the layout wiring method according to any one of the above, or the computer program, when executed by a processor, implements the layout versus schematic comparison method according to any one of claims.

The technical solutions provided by the embodiments of the disclosure at least have the following advantages:

At least two ports to be connected having the same name are connected together by using a virtual connection layer, so that the ports having the same name in a layout are connected through an actual connection layer and/or the virtual connection layer. Therefore, when layout versus schematic comparison is performed, it is beneficial to avoid occurrence of a virtual connection error in the layout, that is, it is avoided that some of the ports having the same name in the layout are characterized as being disconnected from each other, thereby facilitating improving the accuracy of layout versus schematic comparison. In addition, the virtual connection layer is added in the layout, the virtual connection layer is always present in the layout, and the virtual connection layer in the layout does not need to be removed subsequently, thereby reducing the number of modifications in layout wiring, and facilitating improving the accuracy and efficiency of layout wiring.

### BRIEF DESCRIPTION OF THE DRAWINGS

One or more embodiments are described by way of example referring to the corresponding figures in the accompanying drawings, and the descriptions are not to be construed as limiting the embodiments. Unless otherwise particularly stated, the figures in the accompanying drawings are not drawn to scale. One or more embodiments are described by way of example referring to the corresponding figures in the accompanying drawings, and the descriptions are not to be construed as limiting the embodiments. Unless otherwise particularly stated, the figures in the accompanying drawings are not drawn to scale. To describe the technical solutions in embodiments of the disclosure or the related art more clearly, the accompanying drawings required for describing the embodiments are briefly introduced below. Apparently, the accompanying drawings in the following description show merely some embodiments of the disclosure, and persons skilled in the art can still derive other accompanying drawings from these accompanying drawings without involving an inventive effort.
FIG. 1 is a flowchart of a layout wiring method according to an embodiment of the disclosure;
FIG. 2 is a schematic diagram of a partial structure of a layout according to an embodiment of the disclosure;
FIG. 3 is another flowchart of a layout wiring method according to an embodiment of the disclosure;
FIG. 4 is still another flowchart of a layout wiring method according to an embodiment of the disclosure;
FIG. 5 is a schematic diagram of a partial structure of a layout according to an embodiment of the disclosure;
FIG. 6 is a flowchart of a layout versus schematic comparison method according to another embodiment of the disclosure;
FIG. 7 is a flowchart of a layout versus schematic comparison method according to still another embodiment of the disclosure; and
FIG. 8 is a schematic structural diagram of an electronic device according to yet another embodiment of the disclosure.

### DETAILED DESCRIPTION

It can be known from the background art that the accuracy and efficiency of layout wiring need to be improved.

In the existing chip design, in order to reduce chip power consumption, multi-voltage design is generally employed, that is, multi-power domain design is employed. Therefore, there are a plurality of ports having different names, the ports having different names are powered by different power domains, and a plurality of ports having the same name are connected through an internal circuit in a schematic, that is, there is no direct connection relationship between at least two ports having the same name and connected through the internal circuit. However, since there is no internal circuit in a layout, a connection relationship between the at least two ports having the same name and connected through the internal circuit cannot be embodied in the layout, thereby causing inconsistency between the layout and the schematic, and further affecting the accuracy and efficiency of layout wiring.

It should be noted that, in one example, a plurality of ports having the same name are connected through an internal circuit in a schematic, which can be understood as: some of the ports having the same name are all in contact with the same substrate and in electrical connection with the same substrate. That is, the some of the ports can supply power to the substrate. In this case, the internal circuit is the substrate, and the some of the ports are connected through the substrate. That is, there is no direct connection relationship between the at least two ports having the same name and connected through the internal circuit. However, the distance between partial substrates being respectively in contact with the some of the ports and in connection with the some of the ports is relatively far, so that the resistance between the some of the ports is large, and a large resistance value enables the some of the ports to be substantially in a disconnected state. Therefore, a connection relationship between the at least two ports having the same name and connected through the internal circuit cannot be embodied in the layout.

Embodiments of the disclosure provide a layout and a wiring method, a comparison method, a fabrication method, a device, and a storage medium. In the layout wiring method, at least two ports to be connected having the same name are connected together by using a virtual connection layer, so that the ports having the same name in a layout are connected through at least one of an actual connection layer or the virtual connection layer. Therefore, when layout versus schematic comparison is performed, it is beneficial to avoid occurrence of a virtual connection error in the layout, that is, it is avoided that some of the ports having the same name in the layout are characterized as being disconnected from each other due to connection through an internal circuit, thereby facilitating improving the accuracy of layout versus schematic comparison. In addition, the virtual connection layer is added in the layout, the virtual connection layer is always present in the layout, and the virtual connection layer in the layout does not need to be removed subsequently, thereby reducing the number of modifications in layout wiring, and facilitating improving the accuracy and efficiency of layout wiring. It should be noted that the some of the ports having the same name are connected through the internal circuit, which can be understood as: the some of the ports are all in contact with the same substrate and in electrical connection with the same substrate. The connection relationship cannot be embodied in the layout. Moreover, the distance between partial substrates being respectively in contact with the some of the ports and in connection with the some of the ports is relatively far, so that the resistance between the some of the ports is large, and a large resistance value enables the some of the ports to be substantially in a disconnected state. Therefore, the some of the ports are characterized as being disconnected from each other in the layout.

The embodiments of the disclosure will be described in detail below with reference to the accompanying drawings. However, it will be understood by persons skilled in the art that in the embodiments of the disclosure, numerous technical details are set forth in order for the reader to better understand the embodiments of the disclosure. However, even without these technical details and various changes and modifications based on the following embodiments, the technical solutions set forth in the embodiments of the disclosure may be implemented.

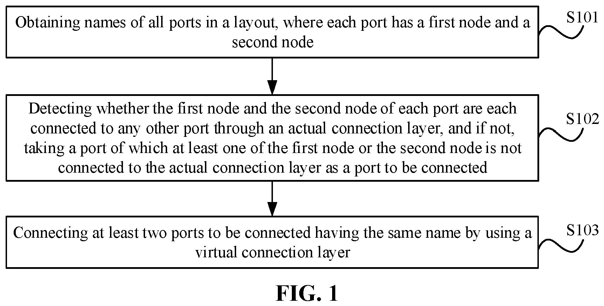

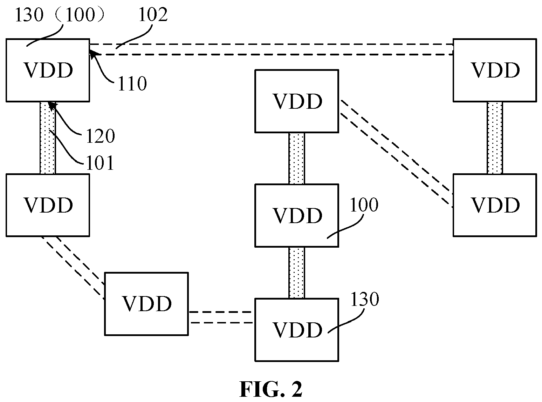

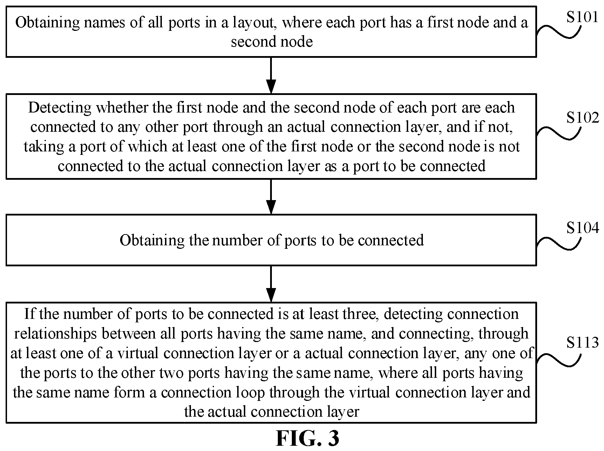

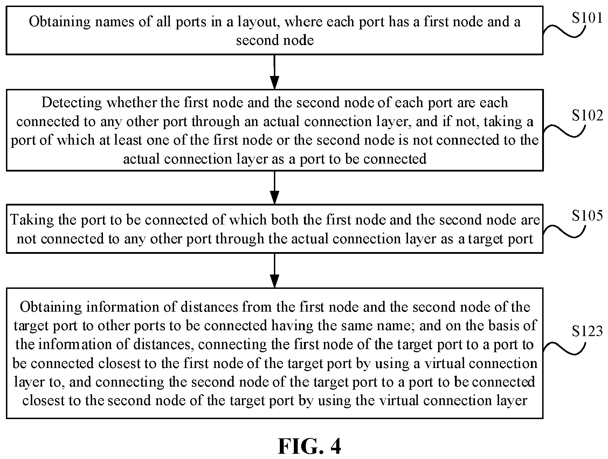

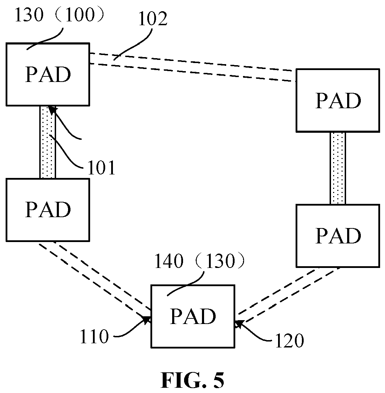

An embodiment of the disclosure provides a layout wiring method. The layout wiring method according to an embodiment of the disclosure will be described in detail below with reference to the accompanying drawings. FIG. 1 is a flowchart of a layout wiring method according to an embodiment of the disclosure; FIG. 2 is a schematic diagram of a partial structure of a layout according to an embodiment of the disclosure; FIG. 3 is another flowchart of a layout wiring method according to an embodiment of the disclosure; FIG. 4 is still another flowchart of a layout wiring method according to an embodiment of the disclosure; and FIG. 5 is a schematic diagram of a partial structure of a layout according to an embodiment of the disclosure.

Referring to FIG. 1 to FIG. 5, the layout wiring method includes the following operations.

In S101, names of all ports 100 in a layout are obtained. Each port 100 has a first node 110 and a second node 120.

The first node 110 and the second node 120 serve as connection nodes through which the port 100 is connected to an actual connection layer 101 or a virtual connection layer 102. It should be noted that, in FIG. 2 and FIG. 5, the case where each port 100 only has a first node 110 and a second node 120 is taken as an example. Therefore, implementation of connection between the ports 100 through few actual connection layers 101 and virtual connection layers 102 is facilitated, and a connection relationship between the plurality of ports 100 is simplified. In practical application, the number of the first nodes 110 or the second nodes 120 included in each port 100 is not limited.

In addition, FIG. 2 and FIG. 5 only illustrate the port 100 named VDD. An actual layout further includes other names, such as the port 100 named VSS.

In S 102, whether the first node 110 and the second node 120 of each port 100 are each connected to any other port 100 through an actual connection layer 101 is detected, and if not, a port 100 of which at least one of the first node 110 or the second node 120 is not connected to the actual connection layer 101 is taken as a port to be connected 130.

It should be noted that the ports 100 in the layout, each of which at least one of the first node 110 or the second node 120 is not connected to the actual connection layer 101, are connected through an internal circuit in a schematic, or the ports 100 in the layout, each of which at least one of the first node 110 or the second node 120 is not connected to the actual connection layer 101, are powered by different power domains in a schematic. Therefore, in the schematic, the ports 100 having the same name are all at the same potential, which realize the same potential through the actual connection layer or through connection by the internal circuit, or by respectively providing a voltage to the ports 100 by at least two power domains providing the same voltage.

However, the manner in which the ports 100 having the same name are at the same potential through the internal circuit or different power domains providing the same voltage cannot be accurately embodied in the layout. Therefore, in the process of layout wiring, the port to be connected 130 of which at least one of the first node 110 or the second node 120 is not connected to the actual connection layer 101 needs to be processed, so as to eliminate adverse effects to layout wiring caused by a difference between the schematic and the layout due to the reason above.

It should be noted that the some of the ports 100 having the same name are connected through the internal circuit, which can be understood as: the some of the ports 100 are in contact with the same substrate and in electrical connection with the same substrate. The connection relationship cannot be embodied in the layout. That is, the case where the some of the ports 100 are at the same potential cannot be embodied in the layout, and the some of the ports are characterized as being disconnected from each other.

In S103, at least two ports to be connected 130 having the same name are connected by using a virtual connection layer 102.

Thus, it is beneficial to enable the ports 100 having the same name in the layout to be connected through the actual connection layer 101 and/or the virtual connection layer 102. Therefore, when layout versus schematic comparison is performed, it is beneficial to avoid occurrence of a virtual connection error in the layout, that is, it is avoided that some of the ports 100 having the same name in the layout are characterized as being disconnected from each other, thereby facilitating improving the accuracy of layout versus schematic comparison. In addition, the virtual connection layer 102 is added in the layout, the virtual connection layer 102 is always present in the layout, and the virtual connection layer 102 in the layout does not need to be removed and the actual connection layer 101 does not need to be modified subsequently, thereby facilitating avoiding an unnecessary error caused by modifying the actual connection layer 101, facilitating reducing the number of modifications in layout wiring, and thus facilitating improving the accuracy and efficiency of layout wiring.

In addition, in the schematic, different power domains providing the same voltage respectively supply power to the some of the ports 100 having the same name, thereby facilitating isolating at least two ports 100 having the same name, so as to reduce the influence of noise between the ports 100.

The specific operations for connecting the at least two ports to be connected 130 having the same name by using the virtual connection layer 102 are described in detail below by means of two embodiments.

In some embodiments, referring to FIG. 3, in addition to the operations S101-S103, the layout wiring method may further include: before the at least two ports to be connected 130 having the same name are connected by using the virtual connection layer 102, S104, the number of ports to be connected 130 is obtained. If the number of ports to be connected 130 is at least three, operation S103 that the at least two ports to be connected 130 having the same name are connected by using the virtual connection layer 102 may include that connection relationships between all ports 100 having the same name are detected, and any one of the ports 100 to be connected is connected to the other two ports 100 having the same name through the virtual connection layer 102 and/or the actual connection layer 101. All ports 100 having the same name form a connection loop through the virtual connection layer 102 and the actual connection layer 101, namely, operation S 113.

It should be noted that, referring to FIG. 2, there is only one connection loop formed by all ports 100 having the same name through the virtual connection layer 102 and the actual connection layer 101. If there is only one connection loop, any one of the ports 100 only has one first node 110 and one second node 120. The first node 110 and the second node 120 are respectively connected to the first node 110 or the second node 120 of the other ports 100 through the virtual connection layer 102 and/or the actual connection layer 101. There is only one connection loop formed by all ports 100 having the same name through the virtual connection layer 102 and the actual connection layer 101, thereby reducing the complexity of the connection loop, thus facilitating an operator to intuitively know, from the layout, whether the ports 100 having the same name are all connected to the same potential, and also facilitating reducing the time consumed when layout versus schematic comparison is performed subsequently. In practical application, the number of connection loops formed by all ports 100 having the same name through the virtual connection layer 102 and the actual connection layer 101 may not be limited, and it is only required to enable all ports 100 having the same name to be at the same potential.

In other embodiments, referring to FIG. 4 and FIG. 5, in addition to the above operations S101-S103, the layout wiring method may further include: before the at least two ports to be connected 130 having the same name are connected by using the virtual connection layer 102, S105: the port to be connected 130 of which the first node 110 and the second node 120 are not connected to any other port 100 through the actual connection layer 101 is used as a target port 140; and operation S103 that the at least two ports to be connected 130 having the same name are connected by using the virtual connection layer 102 may include that information of distances from the first node 110 and the second node 120 of the target port 140 to other ports to be connected 130 having the same name is obtained; and on the basis of the information of distances, the first node 110 of the target port 140 is connected to a port to be connected 130 closest to the first node 110 of the target port 140 using the virtual connection layer 102, and the second node 120 of the target port 140 is connected to a port to be connected 130 closest to the second node 120 of the target port 140 using the virtual connection layer 102, that is, operation S123.

Therefore, it is beneficial to enable the target port 140 to be connected to two ports to be connected 100 closest to the target port 140, thereby simplifying the connection loop formed by all ports 100 having the same name through the virtual connection layer 102 and the actual connection layer 101, facilitating subsequent analysis of the operator for a designed layout and continuous error correction for the designed layout, and also facilitating improving the accuracy and efficiency of layout wiring.

In conclusion, the layout wiring method according to an embodiment of the disclosure facilitates connection between the ports 100 having the same name through the actual connection layer 101 and/or the virtual connection layer 102. Therefore, when layout versus schematic comparison is performed, it is beneficial to avoid the some of the ports 100 having the same name in the layout from being in a disconnected state, thereby facilitating improving the accuracy of layout versus schematic comparison. In addition, the virtual connection layer 102 is always present in the layout, and the virtual connection layer 102 in the layout does not need to be removed and the actual connection layer 101 does not need to be modified subsequently, thereby facilitating avoiding an unnecessary error caused by modifying the actual connection layer 101, facilitating reducing the number of modifications in layout wiring, and facilitating improving the accuracy and efficiency of layout wiring.

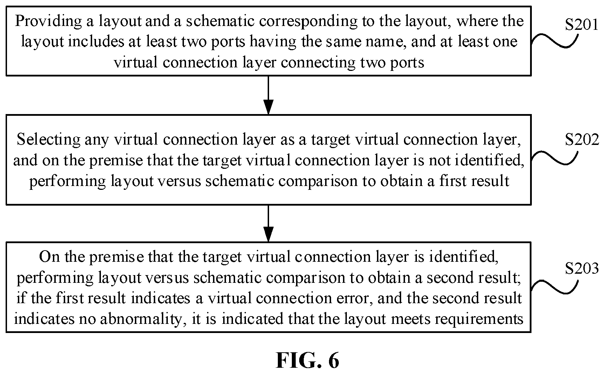

Another embodiment of the disclosure further provides a layout versus schematic comparison method. The layout versus schematic comparison method according to another embodiment of the disclosure will be described in detail below with reference to the accompanying drawings. FIG. 6 is a flowchart of a layout versus schematic comparison method according to another embodiment of the disclosure.

Referring to FIG. 5 and FIG. 6, the layout versus schematic comparison method includes the following operations.

In S201, a layout and a schematic corresponding to the layout are provided. The layout includes at least two ports 100 having a same name, and at least one virtual connection layer 102 connecting two ports 100.

In S202, any one virtual connection layer 102 is selected as a target virtual connection layer, and on the premise that the target virtual connection layer is not identified, layout versus schematic comparison is performed to obtain a first result.

It should be noted that since the virtual connection layer 102 is already present in the layout, in the first result obtained on the premise of not identifying the target virtual connection layer, at least a virtual connection error is shown. That is, there is no connection relationship between the some of the ports 100 having the same name in the layout.

In S203, on the premise that the target virtual connection layer is identified, layout versus schematic comparison is performed to obtain a second result. If the first result indicates a virtual connection error, and the second result indicates no abnormality, it is indicated that the layout meets requirements.

Since the second result indicates no abnormality, it can be determined that the virtual connection error in the first result is caused by the two ports 100 connected by the target virtual connection layer, so that it can be verified that the layout is consistent with the schematic. In addition, it is also beneficial for the operator to learn, on the basis of the layout versus schematic comparison method, which ports 100 in the layout are in virtual connection. The virtual connection can be understood as: the some of the ports 100 are connected through an internal circuit in the schematic, or a potential thereof is controlled by different power domains providing the same voltage. The case where the some of the ports 100 are connected through the internal circuit in the schematic can be understood as: the some of the ports 100 are in contact with the same substrate and in electrical connection with the same substrate. That is, the some of the ports 100 supply power to the substrate, and in this case, the internal circuit is the substrate, and the some of the ports 100 are connected through the substrate. However, the distance between partial substrates being respectively in contact with the some of the ports 100 and in connection with the some of the ports 100 is relatively far, so that the resistance between the some of the ports 100 is large, and a large resistance value enables the some of the ports 100 to be substantially in a disconnected state with each other. Therefore, it is determined that the some of the ports 100 are in virtual connection.

In some embodiments, the layout versus schematic comparison method may further include: if the first result indicates a virtual connection error, and the second result indicates an abnormality, it is detected whether the ports 100 connected by the target virtual connection layer are correct; and the first result and the second result is reobtained by using the target virtual connection layer to connect two other ports 100 that need to be tested, until the layout meets the requirements.

Since the first result indicates a virtual connection error, it is indicated that there is a virtual connection between the some of the ports 100 having the same name in the layout, and it cannot be determined whether the some of the ports 100 are the ports 100 connected by the target virtual connection layer. Moreover, the second result indicates an abnormality, so that it can be determined that the virtual connection error is not caused by the two ports 100 connected by the target virtual connection layer. Therefore, it is necessary to check the two ports 100 connected by the target virtual connection layer by the operator to determine whether the two ports 100 connected by the target virtual connection layer are in a disconnected state.

Then, two other ports 100 that need to be tested are connected by using the target virtual connection layer, so as to re-obtain the first result and the second result. If the first result indicates a virtual connection error, and the second result indicates no abnormality, it can be determined that the virtual connection error in the first result is caused by the two ports 100 currently connected by the target virtual connection layer, so that it can be verified that the layout is consistent with the schematic. It is beneficial for the operator to learn, on the basis of the layout versus schematic comparison method, which ports 100 in the layout are specifically in virtual connection.

In some embodiments, all virtual connection layers 102 are traversed, so that each of the virtual connection layers 102 serves as the target virtual connection layer once. Thus, it is beneficial to verify whether the two ports 100 connected by each virtual connection layer 102 are in a disconnected state with each other, so as to facilitate the operator to correct the layout to improve the accuracy of layout wiring.

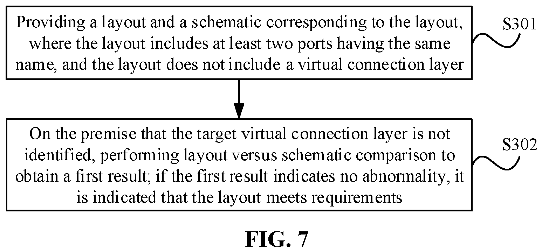

Still another embodiment of the disclosure further provides a layout versus schematic comparison method. The layout versus schematic comparison method according to still another embodiment of the disclosure mainly differs from the layout versus schematic comparison method according to the foregoing embodiments in that before performing layout versus schematic comparison, it is not determined whether there is a virtual connection problem in the layout. The layout versus schematic comparison method according to another embodiment of the disclosure will be described in detail below with reference to the accompanying drawings. FIG. 7 is a flowchart of a layout versus schematic comparison method according to still another embodiment of the disclosure.

Referring to FIG. 5 and FIG. 7, the layout versus schematic comparison method includes the following operations.

In S301, a layout and a schematic corresponding to the layout are provided, The layout includes at least two ports 100 having the same name, and the layout does not include a virtual connection layer 102.

It should be noted that, at this time, the layout does not include a virtual connection layer 102, which does mean that there is no virtual connection layer problem in the layout. That is, all ports 100 having the same name in the layout may have formed a connection loop, or may have not formed a connection loop, it just does not known which ports 100 are in a disconnected state in the layout.

In S302, on the premise that the target virtual connection layer is not identified, layout versus schematic comparison is performed to obtain a first result; and if the first result indicates no abnormality, it is indicated that the layout meets requirements. That is, a virtual connection layer 102 is not required in the layout, and a connection loop has been formed between all ports 100 having the same name.

In some embodiments, if the first result indicates a virtual connection error, the layout versus schematic comparison method may further include that at least two ports 100 that need to be tested are connected using the virtual connection layer 102; and on the premise that the virtual connection layer 102 is identified, the layout versus schematic comparison is performed to obtain a second result; if the second result indicates no abnormality, it is indicated that the layout meets the requirements.

Since the first result indicates a virtual connection error, it is determined that the some of the ports 100 having the same name in the layout are in a disconnected state with each other. The operator can determine, on the basis of experience, which ports 100 are in a disconnected state with each other, connect at least two ports 100 needing to be tested by using the virtual connection layer 102, and then subsequently perform layout versus schematic comparison on the premise that the virtual connection layer 102 is identified, so as to verify whether the at least two ports 100 that need to be tested connected by using the virtual connection layer 102 are correct, that is, whether the at least two ports 100 that need to be tested connected by using the virtual connection layer 102 are the ports 100 having the same name and being a disconnected state in the layout. If the second result indicates no abnormality, it is indicated that the at least two ports 100 that need to be tested connected by using the virtual connection layer 102 are the ports 100 having the same name and being a disconnected state in the layout. Thus, it is beneficial for the operator to learn, on the basis of the layout versus schematic comparison method, which ports 100 in the layout are specifically in virtual connection with each other, and for the operator to correct the layout on the basis of the layout versus schematic comparison method.

In some embodiments, if the second result indicates an abnormality, the layout versus schematic comparison method may further include that: at least two other ports 100 that need to be tested are connected by using the virtual connection layer 102, so as to re-obtain at least one of the first result or the second result until the layout meets the requirements. In this way, the ports 100 having the same name in the layout can be checked successively, so that the operator can correct the layout, so as to improve the accuracy of the layout wiring.

Yet another embodiment of the disclosure further provides a layout, which is formed by the layout wiring method according to an embodiment of the disclosure. The layout according to yet another embodiment of the disclosure will be described in detail below with reference to the accompanying drawings.

Referring to FIG. 2, the layout includes: at least two ports 100 having the same name, where each port 100 has a first node 110 and a second node 120; an actual connection layer 101, connecting some of the ports 100 having the same name, where a first node 110 and/or a second node 120 of each of the some of the ports 100 having the same name are not connected to the actual connection layer 101, and the port 100 of which at least one of the first node 110 or the second node 120 is not connected to the actual connection layer 101 is taken as a port to be connected 130; and a virtual connection layer 102, connecting at least two ports to be connected 130 having the same name.

Thus, it is beneficial to enable the ports 100 having the same name in the layout to be connected with each other through the virtual connection layer 102. Therefore, when layout versus schematic comparison is performed subsequently, it is beneficial to avoid occurrence of a virtual connection error in the layout. That is, it is avoided that some of the ports 100 having the same name in the layout are characterized as being disconnected from each other, thereby facilitating improving the accuracy of layout versus schematic comparison. In addition, the virtual connection layer 102 is always present in the layout, and the virtual connection layer 102 in the layout does not need to be removed and the actual connection layer 101 does not need to be modified subsequently, thereby facilitating improving the accuracy of the designed layout.

In some embodiments, with continued reference to FIG. 2, the number of ports to be connected 130 is at least three, any one of the ports 100 is connected to the other two ports 100 through the virtual connection layer 102 and/or the actual connection layer 101, and all ports 100 having the same name form a connection loop through the virtual connection layer 102 and the actual connection layer 101.

It should be noted that, there is only one connection loop formed by all ports 100 having the same name through the virtual connection layer 102 and the actual connection layer 101, thereby reducing the complexity of the connection loop, thus facilitating the operator to intuitively know, from the layout, whether the ports 100 having the same name are all connected to the same potential, and also facilitating reducing the time consumed when layout versus schematic comparison is performed subsequently. In practical application, the number of connection loops formed by all ports 100 having the same name through the virtual connection layer 102 and the actual connection layer 101 may not be limited, and it is only required to enable all ports 100 having the same name to be at the same potential.

In some embodiments, referring to FIG. 5, some of the ports 130 to be connected each has a first nodes 110 and a second nodes 120 which are all not connected to the actual connection layer 101, and the port to be connected 130 of which both the first node 110 and the second node 120 are not connected to the actual connection layer 101 is taken as a target port 140, where the virtual connection layer 102 connects the first node 110 of the target port 140 to a port to be connected 130 closest to the first node 110 of the target port 140, and the virtual connection layer 102 connects the second node 120 of the target port 140 to a port to be connected 130 closest to the second node 120 of the target port 140.

Therefore, it is beneficial to enable the target port 140 to be connected to two ports to be connected 100 closest to the target port 140, thereby simplifying the connection loop formed by all ports 100 having the same name through the virtual connection layer 102 and the actual connection layer 101, facilitating subsequent analysis of the operator for a designed layout and continuous error correction for the designed layout, and also facilitating improving the accuracy of the designed layout.

Yet another embodiment of the disclosure further provides a circuit fabrication method, which is used to fabricate a circuit corresponding to the layout formed by the layout wiring method according to an embodiment of the present disclosure, or used to fabricate a circuit corresponding to the layout according to yet another embodiment of the disclosure.

The circuit fabrication method includes that a circuit is fabricated according to a layout formed by the layout wiring method provided by an embodiment of the disclosure, or a circuit is fabricated according to the layout provided by yet another embodiment of the disclosure. In the process of fabricating the circuit, a virtual connection layer does not participate in production of fabricating the circuit, and the virtual electric connection layer is not embodied in the circuit. It can be understood that in the circuit fabricated according to the layout provided in the foregoing embodiments, there is no circuit structure corresponding to the virtual connection layer in the layout. That is, the virtual connection layer does not affect a connection relationship between the ports having the same name in the circuit. In addition, in the circuit, different power domains providing the same voltage respectively supply power to the some of the ports having the same name, thereby facilitating isolating at least two ports having the same name, so as to reduce the influence of noise between the ports.

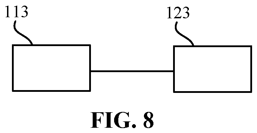

Yet another embodiment of the disclosure further provides an electronic device, which is configured to execute the layout wiring method according to an embodiment of the disclosure, or execute the layout versus schematic comparison method according to another embodiment of the disclosure or still another embodiment of the disclosure. The electronic device according to yet another embodiment of the disclosure will be described in detail below with reference to the accompanying drawings. FIG. 8 is a schematic structural diagram of an electronic device according to yet another embodiment of the disclosure.

Referring to FIG. 8, the electronic device includes: at least one processor 113; and a memory 123 communicatively connected to the at least one processor 113, where the memory 123 stores instructions executable by the at least one processor.

In some embodiments, the instructions may be executed by the at least one processor 113, so that the at least one processor 113 can execute the layout wiring method according to an embodiment of the disclosure, so as to reduce the number of modifications in layout wiring, and improve the accuracy and efficiency of the layout wiring.

In some other embodiments, the instructions may be executed by the at least one processor 113, so that the at least one processor 113 can perform the layout versus schematic comparison according to another embodiment of the disclosure or still another embodiment of the disclosure, which is beneficial for the operator to learn, on the basis of the layout versus schematic comparison method, which ports in the layout are specifically in virtual connection.

Yet another embodiment of the disclosure further provides a computer readable storage medium, which is configured to implement the layout wiring method according to the foregoing embodiments, or implement the layout versus schematic comparison method according to the foregoing embodiments. The computer readable storage medium stores a computer program.

In some embodiments, the computer program, when executed by the processor, implements the layout wiring method according to an embodiment of the disclosure, so as to reduce the number of modifications in layout wiring, and improve the accuracy and efficiency of the layout wiring.

In some other embodiments, the computer program is executed by the processor to implement the layout versus schematic comparison according to another embodiment of the disclosure or still another embodiment of the disclosure, which is beneficial for the operator to learn, on the basis of the layout versus schematic comparison method, which ports in the layout are specifically in virtual connection.

Persons skilled in the art may understand that the foregoing embodiments are specific embodiments for implementing the disclosure, and in practical application, various changes may be made in form and detail without departing from the spirit and scope of the disclosure. Any changes and modifications may be made by persons skilled in the art without departing from the spirit and scope of the disclosure, and therefore, the scope of protection of the disclosure should be subject to the scope defined by the claims.

## Claims

1. A layout wiring method, comprising:
obtaining names of all ports in a layout, wherein each port has a first node and a second node;
detecting whether the first node and the second node of each port are each connected to any other port through an actual connection layer, and if not, taking a port of which at least one of the first node or the second node is not connected to the actual connection layer as a port to be connected; and
connecting at least two ports to be connected having a same name by using a virtual connection layer.

2. The layout wiring method of claim 1, further comprising: before connecting the at least two ports to be connected having the same name by using the virtual connection layer,
obtaining a number of ports to be connected; and
if the number of ports to be connected is at least three, connecting the at least two ports to be connected having the same name by using the virtual connection layer comprises:
detecting connection relationships between all ports having the same name; and
connecting, through at least one of the virtual connection layer or the actual connection layer, any one of the ports to other two ports having the same name, wherein all ports having the same name form a connection loop through the virtual connection layer and the actual connection layer.

3. The layout wiring method of claim 1, further comprising: before connecting the at least two ports to be connected having the same name by using the virtual connection layer,
taking a port to be connected of which both the first node and the second node are not connected to any other port through the actual connection layer as a target port; and
connecting the at least two ports to be connected having the same name by using the virtual connection layer comprises:
obtaining information of distances from the first node and the second node of the target port to other ports to be connected having the same name; and
on the basis of the information of distances, connecting the first node of the target port to a port to be connected closest to the first node of the target port by using the virtual connection layer, and connecting the second node of the target port to a port to be connected closest to the second node of the target port by using the virtual connection layer.

4. A layout versus schematic comparison method, comprising:
providing a layout and a schematic corresponding to the layout, wherein the layout comprises at least two ports having a same name, and at least one virtual connection layer connecting two ports;
selecting any one virtual connection layer as a target virtual connection layer, and on a premise that the target virtual connection layer is not identified, performing layout versus schematic comparison to obtain a first result; and
on a premise that the target virtual connection layer is identified, performing layout versus schematic comparison to obtain a second result, wherein
if the first result indicates a virtual connection error, and the second result indicates no abnormality, it is indicated that the layout meets requirements.

5. The layout versus schematic comparison method of claim 4, wherein the layout versus schematic comparison method further comprises: if the first result indicates a virtual connection error, and the second result indicates an abnormality, detecting whether ports connected by the target virtual connection layer are correct; and connecting two other ports that need to be tested by using the target virtual connection layer, so as to re-obtain the first result and the second result until the layout meets the requirements.

6. The layout versus schematic comparison method of claim 4 or 5, further comprising: traversing all virtual connection layers, so that each of the virtual connection layers serves as the target virtual connection layer once.

7. A layout versus schematic comparison method, comprising:
providing a layout and a schematic corresponding to the layout, wherein the layout comprises at least two ports having a same name, and the layout does not comprise a virtual connection layer; and
on a premise that the virtual connection layer is not identified, performing layout versus schematic comparison to obtain a first result; wherein
if the first result indicates no abnormality, it is indicated that the layout meets requirements.

8. The layout versus schematic comparison method of claim 7, wherein if the first result indicates a virtual connection error, the layout versus schematic comparison method further comprises:
connecting at least two ports that need to be tested by using the virtual connection layer; and
on a premise that the virtual connection layer is identified, performing the layout versus schematic comparison to obtain a second result, wherein
if the second result indicates no abnormality, it is indicated that the layout meets the requirements.

9. The layout versus schematic comparison method of claim 8, wherein if the second result indicates an abnormality, the layout versus schematic comparison method further comprises:
connecting at least two other ports that need to be tested by using the virtual connection layer, so as to re-obtain at least one of the first result or the second result until the layout meets the requirements.

10. A layout, comprising:
at least two ports having a same name, wherein each port has a first node and a second node;
an actual connection layer, connecting some of the ports having the same name, wherein some of the ports having the same name each has at least one of a first node or a second node which is not connected to the actual connection layer, and a port of which at least one of the first node or the second node is not connected to the actual connection layer is taken as a port to be connected; and
a virtual connection layer, connecting at least two ports to be connected having the same name.

11. The layout of claim 10, wherein a number of ports to be connected is at least three, any one of the ports is connected to other two ports through at least one of the virtual connection layer or the actual connection layer, and all ports having the same name form a connection loop through the virtual connection layer and the actual connection layer.

12. The layout of claim 11, wherein some of the ports to be connected each has the first node and the second node which are all not connected to the actual connection layer, and a port to be connected of which the first node and the second node are not connected to the actual connection layer is taken as a target port, wherein the virtual connection layer connects the first node of the target port to a port to be connected closest to the first node of the target port, and the virtual connection layer connects the second node of the target port to a port to be connected closest to the second node of the target port.

13. A circuit fabrication method, comprising: fabricating a circuit according to a layout formed by the layout wiring method of any one of claims 1 to 3, or fabricating a circuit according to the layout of any one of claims 7 to 9, wherein in a process of fabricating the circuit, a virtual connection layer does not participate in production of fabricating the circuit, and the virtual electric connection layer is not embodied in the circuit.

14. An electronic device, comprising:
at least one processor; and
a memory communicatively connected to the at least one processor, wherein
the memory has stored therein instructions executable by the at least one processor, and the instructions are executed by the at least one processor, to cause the at least one processor to execute the layout wiring method of any one of claims 1 to 3, or the instructions are executed by the at least one processor, to cause the at least one processor to execute the layout versus schematic comparison method of any one of claims 4 to 9.

15. A computer readable storage medium, storing a computer program, wherein the computer program, when executed by a processor, implements the layout wiring method of any one of claims 1 to 3, or the computer program, when executed by a processor, implements the layout versus schematic comparison method of any one of claims 4 to 9.
